(19) **Europäisches Patentamt / European Patent Office / Office européen des brevets**

(11) **EP 3 104 421 B1**

(12) **FASCICULE DE BREVET EUROPEEN**

(45) Date de publication et mention
de la délivrance du brevet:
**22.03.2023 Bulletin 2023/12**

(21) Numéro de dépôt: **16173520.4**

(22) Date de dépôt: **08.06.2016**

(51) Classification Internationale des Brevets (IPC):
**H01L 31/107** (2006.01)    **H01L 27/144** (2006.01)

(52) Classification Coopérative des Brevets (CPC):
**H01L 31/107; H01L 27/1446**

(54) **PHOTODIODE SPAD COUVERTE D'UN RÉSEAU**

MIT EINEM GITTER ABGEDECKTE SPAD-FOTODIODE

SPAD PHOTODIODE COVERED WITH A GRATING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.06.2015 FR 1555326**

(43) Date de publication de la demande:
**14.12.2016 Bulletin 2016/50**

(73) Titulaire: **Commissariat à l'Energie Atomique et aux Energies Alternatives**
**75015 Paris (FR)**

(72) Inventeurs:
• **FREY, Laurent**
  **38600 Fontaine (FR)**
• **MOUSSY, Norbert**
  **38190 Sainte-Agnes (FR)**

(74) Mandataire: **Brevalex**
**56, Boulevard de l'Embouchure**
**B.P. 27519**
**31075 Toulouse Cedex 2 (FR)**

(56) Documents cités:
CN-B- 102 881 761    JP-A- H03 152 978
US-A1- 2011 018 086    US-A1- 2011 241 149
US-A1- 2015 053 924

• LIU, SONGHAO ET AL: "Photonic technology in quantum information challenges quantum limitation", PROC. OF SPIE, QUANTUM OPTICS, OPTICAL DATA STORAGE, AND ADVANCED MICROLITHOGRAPHY, 11 novembre 2007 (2007-11-11), pages 1-12, XP040249793, DOI: 10.1117/12.756908
• JASON J. ACKERT ET AL: "10 Gbps silicon waveguide-integrated infrared avalanche photodiode", OPTICS EXPRESS, vol. 21, no. 17, 12 août 2013 (2013-08-12) , pages 19530-19537, XP055313981, DOI: 10.1364/OE.21.019530
• VASILE, STEFAN ET AL: "Challenges of developing resonant cavity photon-counting detectors at 1064nm", PROC. OF SPIE, FREE-SPACE LASER COMMUNICATION TECHNOLOGIES XXII, 23 janvier 2010 (2010-01-23), pages 75870T-1-75870T-8, XP040517885, DOI: 10.1117/12.845260
• JIAN MA ET AL: "High-efficiency and low-jitter Silicon single-photon avalanche diodes based on nanophotonic absorption enhancement", ARXIV.ORG, CORNELL UNIVERSITY LIBRARY, 201 OLIN LIBRARY CORNELL UNIVERSITY ITHACA, NY 14853, 6 May 2015 (2015-05-06), XP081337024,

**EP 3 104 421 B1**

**Description**

**DOMAINE TECHNIQUE**

La présente invention concerne le domaine des photodiodes, en particulier les photodiodes de type SPAD.

**ÉTAT DE LA TECHNIQUE ANTÉRIEURE**

Une photodiode est un composant sensible à la lumière, comprenant une couche en matériau semi-conducteur présentant une zone dopée N (présentant un excès d'électrons) et une zone dopée P (présentant un défaut d'électrons). La zone dopée N et la zone dopée P sont séparées par une jonction PN, au niveau de laquelle se forme une zone de déplétion, également nommée zone de charge d'espace. Chaque zone dopée N ou P est reliée à un connecteur électrique, afin de polariser la diode. Un photon absorbé par la couche en matériau semi-conducteur génère une paire électron-trou, c'est-à-dire une charge électrique positive et une charge électrique négative.

Dans une photodiode dite SPAD, pour l'anglais « *single-photon avalanche diode* », une polarisation inverse est appliquée entre la zone dopée N et la zone dopée P. La tension de polarisation est de préférence supérieure (ou égale), en valeur absolue, à la tension de claquage de la photodiode (tension électrique inverse minimum qui la rend conductrice dans le sens bloquant). Cette polarisation crée un fort champ électrique au niveau de la jonction PN, qui accélère les charges électriques photo-générées. Ces charges ont suffisamment d'énergie pour exciter par impact d'autres charges électriques (ionisation par impact). Cette réaction en chaîne est nommée effet d'avalanche, et a lieu dans une zone dite d'avalanche entre la zone dopée N et la zone dopée P. Ainsi, l'absorption d'un photon génère un signal électrique bref et intense, dit signal électrique utile. Une photodiode de type SPAD permet donc de détecter avec une grande précision des signaux lumineux de très faible intensité et de dater l'arrivée de chaque photon. Une photodiode de type SPAD est également nommée photodiode à avalanche en mode Geiger.

La demande de brevet US 2011/018086 A1 décrit par exemple une matrice de photodiodes à avalanche, dans laquelle une série de zones dopées P est réalisée par diffusion d'ions dopants à travers les ouvertures d'un masque.

Dans l'article « Photonic technology in quantum information challenges quantum limitation », Proc. of SPIE Vol. 6827, 68270F (2007), les auteurs s'intéressent à une injection latérale dans une photodiode à avalanche, dans le cadre d'un dispositif de télécommunications.

Dans la demande de brevet JP H03 152978 A, il est décrit un couplage entre une fibre optique et une photodiode à avalanche, à l'aide d'un réseau de pas variable.

Dans l'article « 10 Gbps silicon waveguide-integrated infrared avalanche photodiode », OPTICS EXPRESS, Vol. 21, No. 17, 12 août 2013, p. 19530-19537 les auteurs décrivent une photodiode à avalanche intégrée avec un guide d'onde sur un même substrat.

Si le photon est absorbé dans la zone d'avalanche, la paire électron-trou déclenche immédiatement l'effet d'avalanche. Si le photon est absorbé hors de la zone d'avalanche, la charge minoritaire de la paire électron-trou peut diffuser dans la couche en matériau semi-conducteur puis atteindre la zone d'avalanche où elle déclenche l'effet d'avalanche.

La résolution temporelle du signal électrique utile est donc limitée par l'incertitude sur l'emplacement précis où est absorbé le photon et où se forme la paire électron-trou. En d'autres termes, le temps de transit du porteur généré, jusqu'à la zone d'avalanche, n'est pas connu avec précision, ce qui limite la résolution temporelle de la détection de photons. Cette dispersion temporelle est nommée également gigue de la photodiode, ou « jitter » en anglais.

On pourrait envisager de réduire l'épaisseur de la photodiode, à une épaisseur proche de celle de la zone d'avalanche. Cependant, la zone d'avalanche présente généralement une très faible épaisseur, typiquement de l'ordre de 0,3 $\mu$m. Cette solution ne permet donc pas d'absorber suffisamment de photons pour offrir à la photodiode une sensibilité satisfaisante. En effet, il faut une certaine épaisseur de matériau pour absorber la lumière, cette épaisseur dépendant de la longueur d'onde considérée et augmentant en allant vers l'infra-rouge, notamment pour le silicium. Par exemple, il faut une épaisseur supérieure à 1 $\mu$m de silicium, pour absorber efficacement le proche infra-rouge dans le silicium.

Une solution connue pour offrir à la fois une bonne résolution temporelle et une grande sensibilité consiste donc à augmenter l'épaisseur de matériau semi-conducteur afin d'absorber efficacement les photons incidents, et accélérer les porteurs migrant vers la zone d'avalanche afin de diminuer le « jitter ». Pour accélérer les porteurs vers la zone d'avalanche, on crée un champ électrique dans toute l'épaisseur de la couche en matériau semi-conducteur. Ceci est réalisé en abaissant le niveau de dopage moyen du matériau semi-conducteur, et en augmentant (en valeur absolue) la tension de polarisation aux bornes de la diode.

Un inconvénient de cette solution est qu'elle nécessite l'utilisation de tensions de polarisation très élevées.

Une autre solution est décrite par Jian Ma & al. dans l'article « High-efficiency and low-jitter Silicon single-photon avalanche diodes based on nanophotonic absorption enhancement », arXiv.org, 6 mai 2015, p. 1-7.

Elle consiste à placer la photodiode de type SPAD à l'intérieur d'un piège à lumière qui diffuse la lumière. La longueur du trajet de la lumière dans la photodiode est ainsi augmentée, ce qui augmente une probabilité d'absorption par cette dernière.

Un objectif de la présente invention est de proposer une photodiode de type SPAD présentant une grande sensibilité, et qui ne présente pas au moins l'un des inconvénients de l'art antérieur.

En particulier, un but de la présente invention est de proposer une photodiode de type SPAD présentant à la fois une grande sensibilité dans les grandes longueurs d'onde (supérieure à 600 nm, et même 800 nm) et une faible gigue.

## EXPOSÉ DE L'INVENTION

Cet objectif est atteint avec une photodiode telle que décrite dans la revendication 1.

De préférence, la zone dopée P et la zone dopée N s'étendent chacune d'un seul tenant sous l'ensemble de la structure périodique.

De préférence, la structure périodique comprend une pluralité de plots régulièrement espacés, les espaces entre les plots étant au moins partiellement remplis par un matériau dit matériau bas indice, présentant un indice de réfraction inférieur à celui de la couche en matériau semi-conducteur et à celui de la structure périodique.

En variante, les espaces entre les plots sont remplis en totalité ou en partie par un gaz tel que de l'air.

En tout état de cause, dans ces deux cas l'indice de réfraction moyen entre les plots est inférieur à l'indice de réfraction des plots, la différence entre les deux étant supérieure ou égale à 0,5 voire même supérieure ou égale à 1.

Avantageusement, la structure périodique présente un dopage N ou P, et un seul des motifs élémentaires est relié à un élément de contact électrique, pour polariser la photodiode.

La couche en matériau semi-conducteur peut être en silicium, et la première couche bas indice en dioxyde de silicium.

De préférence, une différence entre l'indice de réfraction de la couche en matériau semi-conducteur et l'indice de réfraction de la première couche bas indice est supérieure ou égale à 0,5.

La structure périodique présente avantageusement un pas compris entre 100 nm et 1000 nm.

L'épaisseur de la couche en matériau semi-conducteur est avantageusement comprise entre 0,5 $\mu$m et 3 $\mu$m.

La hauteur des motifs élémentaires est de préférence inférieure à 1 $\mu$m.

De préférence, une différence entre l'indice de réfraction de la couche en matériau semi-conducteur et l'indice de réfraction de la première couche bas indice est supérieure ou égale à 0,5.

La structure périodique présente avantageusement un pas compris entre 100 nm et 1000 nm.

L'épaisseur de la couche en matériau semi-conducteur est avantageusement comprise entre 0,5 $\mu$m et 3 $\mu$m.

La hauteur des motifs élémentaires est de préférence inférieure à 1 $\mu$m.

Un rapport de la largeur d'un plot, divisée par le pas de la structure périodique peut être compris entre 0,25 et 0,80.

La structure périodique forme de préférence un réseau en deux dimensions, le pas de ce réseau étant identique dans chacune desdites deux dimensions.

La structure périodique est formée dans un même bloc en matériau semi-conducteur que la couche en matériau semi-conducteur ou formée dans une couche en silicium poly-cristallin déposée sur la couche en matériau semi-conducteur.

En tout état de cause, la photodiode est configurée pour détecter un rayonnement électromagnétique, qui traverse la structure périodique avant d'atteindre la couche en matériau semi-conducteur.

L'invention concerne également une matrice d'au moins deux photodiodes dans laquelle :

- chaque structure périodique comprend une pluralité de plots régulièrement espacés, les espaces entre les plots étant au moins partiellement remplis par un matériau dit matériau bas indice, présentant un indice de réfraction inférieur à celui de la couche en matériau semi-conducteur et à celui de la structure périodique ; et
- les structures périodiques voisines sont séparées par des tranchées remplies par ledit matériau bas indice.

L'invention concerne également un procédé de fabrication d'une matrice de photodiodes selon la revendication 12, comprenant les étapes suivantes :

- structuration d'une région supérieure d'un bloc en matériau semi-conducteur, pour former un ensemble constitué par une pluralité de structures périodiques montées sur une couche en matériau semi-conducteur ;
- gravure de tranchées entre deux structures périodiques voisines, les étapes de gravure de tranchées et de structuration étant réalisées par une unique étape de gravure ; et
- dépôt du matériau bas indice, remplissant les tranchées et les espaces entre des plots formant les structures périodiques, ledit matériau bas indice présentant un indice de réfraction inférieur à celui du bloc en matériau semi-conducteur.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :

- la figure 1 illustre de manière schématique un premier mode de réalisation d'une photodiode selon l'invention ;
- la figure 2 illustre de manière schématique un deuxième mode de réalisation d'une photodiode selon l'invention ;
- la figure 3 illustre une répartition de l'absorption de la lumière dans la photodiode illustrée en figure 2 ;
- la figure 4 illustre l'efficacité quantique dans une photodiode selon l'invention ;
- la figure 5 illustre un procédé de fabrication d'un exemple de photodiode selon le deuxième mode de réalisation de l'invention ;
- la figure 6 illustre un troisième mode de réalisation d'une photodiode selon l'invention ;
- la figure 7 illustre un quatrième mode de réalisation d'une photodiode selon l'invention ;
- la figure 8 illustre un cinquième mode de réalisation d'une photodiode selon l'invention ; et
- la figure 9 illustre une répartition de l'absorption de la lumière dans la photodiode illustré en figure 8.

## EXPOSÉ DÉTAILLÉ DE MODES DE RÉALISATION PARTICULIERS

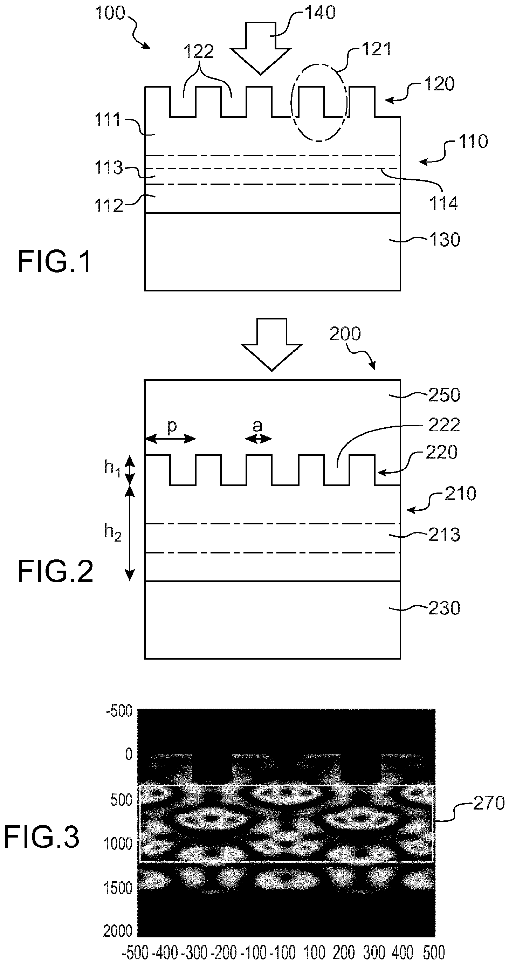

On va tout d'abord illustrer l'invention à l'aide de la figure 1, illustrant de manière schématique un premier mode de réalisation d'une photodiode 100 selon l'invention.

La photodiode 100 est adaptée à détecter un rayonnement électromagnétique à des longueurs d'onde dans le rouge et le proche infrarouge, comprises notamment entre 600 nm et 1000 nm. Dans la suite, on prend l'exemple d'une photodiode adaptée à détecter un rayonnement électromagnétique à 850 nm.

La photodiode 100 présente une couche en matériau semi-conducteur 110, présentant une zone dopée N 111 et une zone dopée P 112. La zone dopée N 111 et la zone dopée P 112 sont superposées, et séparées par une jonction PN 114. Une zone d'avalanche 113 (représentée entre deux traits mixtes) s'étend dans et autour de la jonction PN. En variante, la zone 111 est dopée P, et la zone 112 est dopée N.

La photodiode 100 est de type SPAD, adaptée à être polarisée en inverse par une tension de polarisation supérieure à la tension de claquage, par exemple comprise entre 1 et 3 fois la tension de claquage. En particulier, la zone dopée N 111 est reliée à un premier connecteur électrique (non représenté) adapté à être porté à un premier potentiel électrique, et la zone dopée P est reliée à un second connecteur électrique (non représenté) adapté à être porté à un second potentiel électrique, les premier et second potentiels électriques définissant ensemble une tension supérieure (en valeur absolue) à la tension de claquage.

Le matériau semi-conducteur forme un milieu absorbant, constitué par exemple de silicium, la photodiode étant adaptée à détecter un rayonnement électromagnétique 140 à une longueur d'onde de 850 nm.

Une structure périodique 120 est disposée directement sur la couche en matériau semi-conducteur 110.

Comme illustré sur l'ensemble des figures, la zone dopée P et la zone dopée N s'étendent chacune d'un seul tenant sous l'ensemble de la structure périodique.

Cette structure périodique 120 peut être gravée dans un bloc en matériau semi-conducteur, de façon à former directement l'ensemble constitué par la couche 110 et la structure périodique 120. En variante, la structure périodique 120 est faite d'un matériau non métallique, différent de celui de la couche 110.

Comme illustré sur l'ensemble des figures, la photodiode selon l'invention est configurée pour détecter un rayonnement électromagnétique 140, incident sur la photodiode du côté de la structure périodique 120.

En d'autres termes, la photodiode est configurée pour détecter un rayonnement électromagnétique 140, qui traverse la structure périodique 120 avant d'atteindre la couche en matériau semi-conducteur 110.

Le matériau formant la structure périodique 120 est donc essentiellement transparent à la longueur d'onde que la photodiode 100 est adaptée à détecter. Dans tout le texte « essentiellement transparent » signifie par exemple « présentant un coefficient d'extinction inférieur à quelques $10^{-2}$ à la longueur d'onde de travail, par exemple $5 \cdot 10^{-2}$ ».

La structure périodique 120 présente une pluralité de motifs élémentaires, c'est-à-dire une pluralité de plots 121 régulièrement espacés les uns des autres. Un plot désigne ici un volume plein de forme quelconque, par exemple un cylindre, ou un cube, ou un anneau cylindrique, ou un cube percé d'un trou traversant (les plusieurs plots dessinant alors une grille). La forme du plot peut conférer à la structure périodique une périodicité selon une ou deux dimensions de l'espace. Dans le premier cas, on parle également de barre, ou de ligne. La structure périodique 120 présente de préférence une périodicité selon deux dimensions, associées chacune à un axe parallèle à la surface supérieure de la photodiode.

La période peut être différente selon chacune des deux dimensions. On a alors une efficacité quantique qui dépend de la polarisation de la lumière, ce qui peut permettre de détecter une polarisation particulière. La structure périodique présente avantageusement au moins cinq motifs élémentaires selon chaque dimension de l'espace où elle présente une périodicité (soit au moins 5x5 motifs élémentaires dans le cas d'une périodicité selon deux dimensions).

La structure périodique 120 peut être recouverte d'une fine couche de passivation (oxyde thermique par exemple), qui suit la forme des motifs élémentaires sans combler entièrement les espaces, ou interstices 122 entre eux/elles. L'indice optique de cette couche de passivation peut être quelconque.

La structure périodique 120 forme un réseau résonnant sub-longueur d'onde, le pas étant inférieur à la longueur d'onde dans le matériau du milieu incident, du rayonnement électromagnétique que la photodiode 100 est adaptée à détecter. Le milieu incident est celui qui recouvre la structure périodique, ici de l'air. Le pas est donc, ici, inférieur à 850 nm.

Ici, ce matériau est de l'air (le milieu incident est le milieu). Ce pas est notamment inférieur à 850 nm.

On rappelle que la longueur d'onde dans un matériau est la longueur d'onde dans le vide divisée par l'indice optique de ce matériau.

La couche en matériau semi-conducteur 110 est déposée directement sur une première couche dite bas indice 130, présentant un indice de réfraction inférieur à celui de la couche 110 et celui de la structure périodique 120. Dans tout le texte, on considère des indices de réfraction à une longueur d'onde que la photodiode est adaptée à détecter, en particulier à 850 nm.

La première couche bas indice 130 forme une gaine inférieure d'un guide d'onde. La gaine supérieure du guide d'onde est formée ici par l'air entourant la photodiode, et remplissant ici les espaces 122 entre les plots (ou ce qu'il en subsiste après application de la fine couche de passivation définie plus haut).

La combinaison de ce guide d'onde et de la structure périodique 120 engendre des modes guidés dans la couche en matériau semi-conducteur 110.

On constate de façon surprenante que pour certaines valeurs des paramètres géométriques de la photodiode (dimensions des plots de la structure périodique 120, épaisseurs de la structure périodique 120 et de la couche en matériau semi-conducteur 110), le champ électromagnétique est renforcé localement dans des régions situées à l'intérieur de la couche en matériau semi-conducteur 110, et que ce champ est quasiment nul dans la structure périodique. En particulier, le champ électromagnétique est concentré dans au moins une sous-couche de la couche en matériau semi-conducteur 110. L'homme du métier aurait attendu une répartition plus homogène du champ électromagnétique dans un guide d'onde multimode de forte épaisseur (ici environ 5 à 10 fois la longueur d'onde dans la couche en matériau semi-conducteur 110, voir plus loin).

Les régions dans lesquelles le champ électromagnétique est plus intense sont utilisées pour réaliser une photodiode de type SPAD de même sensibilité et de plus grande résolution temporelle, comparée à une photodiode SPAD selon l'art antérieur.

Pour cela, on positionne les régions où le champ électromagnétique est renforcé dans ou à proximité de la zone d'avalanche de la photodiode SPAD. Ainsi, l'absorption des photons est renforcée dans ou à proximité de la zone d'avalanche. On peut alors réduire l'épaisseur d'une région du matériau semi-conducteur située en dehors de la zone d'avalanche, et dont le rôle est simplement d'absorber des photons qui diffuseront ensuite jusqu'à la zone d'avalanche.

Dans l'art antérieur, une photodiode SPAD détectant un rayonnement à 850 nm et absorbant 90% des photons incidents, est constituée d'une couche de silicium de 40 $\mu$m d'épaisseur. Grâce à l'invention, on ramène cette épaisseur à quelques micromètres seulement, en tout état de cause moins de 10 $\mu$m.

Grâce à cette épaisseur réduite, le temps de transit des porteurs jusqu'à la zone d'avalanche est réduit. On peut ainsi, à sensibilité égale, à la fois réduire la tension de polarisation et améliorer la résolution temporelle de la photodiode SPAD (c'est-à-dire réduire la gigue). Par exemple, on réduit d'un facteur deux cette tension de polarisation (20 V au lieu de 40 V). On obtient une photodiode à faible dispersion temporelle et forte efficacité quantique.

Une photodiode de type SPAD est utilisée par exemple pour mesurer un temps de vol, c'est-à-dire une durée écoulée entre l'émission d'un signal laser, et la détection d'un signal rétrodiffusé sur un objet à détecter. Les mesures de temps de vol sont utilisées couramment en télémétrie, détection de présence, reconnaissance de mouvement en 3D, etc. L'invention permet d'augmenter la précision de cette mesure de temps de vol.

L'invention évite en outre d'avoir à abaisser le niveau de dopage moyen dans la couche en matériau semi-conducteur, ce qui s'avère particulièrement avantageux en technologie CMOS.

L'épaisseur réduite de la couche en matériau semi-conducteur permet également de réduire le courant d'obscurité. Cet avantage se retrouve dans n'importe quel type de photodiode, les régions où le champ électromagnétique est renforcé étant positionnées dans ou à proximité de la jonction PN.

La figure 2 illustre de manière schématique un deuxième mode de réalisation d'une photodiode 200 selon l'invention. La photodiode 200 ne diffère de la photodiode illustrée en figure 1, qu'en ce que les espaces 222 entre les plots, sont remplis par un matériau bas indice (matériau solide). Le matériau bas indice présente un indice de réfraction inférieur à celui de la couche en matériau semi-conducteur 210 et celui de la structure périodique 220. De préférence, ce matériau bas indice est identique au matériau de la première couche bas indice.

De préférence, les espaces 222 sont entièrement remplis par le matériau bas indice. Le matériau bas indice forme une deuxième couche bas indice 250. Il peut constituer une couche de passivation entre les plots, en contact direct avec la structure périodique 210.

La deuxième couche bas indice 250 est essentiellement transparente à la longueur d'onde que la photodiode 200 est adaptée à détecter.

Dans l'exemple illustré en figure 2, la deuxième couche bas indice 250, constituée dudit matériau bas indice, recouvre la structure périodique 210, s'insère entre les plots 210 et dépasse au-dessus de ces derniers.

Selon une variante non représentée, ladite deuxième couche bas indice 250 affleure au sommet des plots. Une troisième couche peut alors recouvrir l'ensemble ainsi formé, du côté des plots. Cette troisième couche est alors essentiellement transparente à la longueur d'onde que la photodiode 200 est adaptée à détecter. Cette troisième couche peut être constituée d'un matériau présentant un indice de réfraction inférieur à celui de la couche en matériau semi-conducteur 210 et celui de la structure périodique 220. La troisième couche et la deuxième couche bas indice peuvent être constituées de matériaux différents.

La figure 3 illustre une répartition de l'absorption dans la photodiode 200. On observe que l'absorption présente de grandes variations d'intensité, et se concentre essentiellement dans des régions situées en dehors de la structure périodique 220, à l'intérieur de la couche 210 en matériau semi-conducteur (la représentation en noir et blanc perd une partie de l'information). On a représenté par un rectangle blanc une sous-couche 270 de la couche 210 en matériau semi-conducteur, recevant les régions où se concentre l'absorption. Par exemple, la sous-couche 270 absorbe 75% d'un flux lumineux incident, et présente une épaisseur proche de 1 $\mu$m. La sous-couche 270 est nommée région de haute sensibilité. On positionne la zone d'avalanche 213 dans cette sous-couche 270.

On décrit dans la suite des dimensions et indices préférentiels de la photodiode selon l'invention, la longueur d'onde à détecter étant choisie égale à 850 nm.

La différence d'indice entre la couche en matériau semi-conducteur 210 et la première couche bas indice 230 est supérieure à 0,5, de préférence supérieure à 1.

De la même façon, la différence d'indice entre la structure périodique 220 et la première couche bas indice 230 est supérieure à 0,5, de préférence supérieure à 1.

Lorsque la photodiode comprend une deuxième couche bas indice, les mêmes différences d'indice sont vérifiées entre cette deuxième couche, et la couche en matériau semi-conducteur, respectivement la structure périodique.

En tout état de cause, lorsque les espaces entre les plots sont remplis au moins en partie par un gaz tel que de l'air, ces mêmes différences d'indice sont vérifiées entre l'indice moyen entre les plots, et la couche en matériau semi-conducteur, respectivement la structure périodique.

Par exemple, la couche en matériau semi-conducteur et la structure périodique sont en silicium (n=3,65 à 850 nm), et la première couche bas indice (et le cas échéant la deuxième couche bas indice) est en dioxyde de silicium (n=1,45 à 850 nm).

La première couche bas indice 230 présente avantageusement une épaisseur supérieure à 50 nm, de préférence supérieure à 500 nm.

L'épaisseur de la couche en matériau semi-conducteur 210 est notée $h_2$. Plus cette épaisseur est importante, plus la densité spectrale des modes dans la couche en matériau semi-conducteur est importante. Une grande densité spectrale de modes offre une grande acceptance angulaire de la photodiode. De préférence, $h_2$ est supérieur à 0,7 $\mu$m lorsque la structure périodique 220 présente une périodicité selon deux dimensions. On obtient ainsi une efficacité quantique, moyennée sur un cône d'angles d'incidence de quelques dizaines de degrés, supérieur d'un facteur 5 à 10 par rapport à l'art antérieur, sur une largeur spectrale de plusieurs centaines de nanomètres. Cette condition correspond à $h_2$ supérieure à 1,0 $\mu$m lorsque la structure périodique 220 présente une périodicité selon une seule dimension.

En tout état de cause, l'épaisseur $h_2$ est supérieure à 0,5 $\mu$m, afin de bénéficier d'une absorption suffisante.

L'épaisseur $h_2$ est de préférence inférieure à 3 $\mu$m.

La hauteur $h_1$ pic-vallée des plots de la structure périodique est inférieure ou égale à 1 $\mu$m, typiquement comprise entre 0,1 $\mu$m et 1,0 $\mu$m.

Les plots sont par exemple des cubes de côté *a*. En variante, il peut s'agir de plots cylindriques de diamètre *a*. En variante, la structure périodique est formée par des barres de largeur *a*, par exemple des parallélépipèdes à base rectangulaire.

Le rapport $\dfrac{a}{P}$ entre la largeur *a* des plots, et le pas P de la structure périodique, est compris entre 0,25 et 0,80 (la largeur *a* et le pas P étant mesurés selon le même axe). Ce rapport est vérifié selon un ou deux axes, selon que la structure périodique 220 présente une périodicité selon une ou deux dimensions.

Un fonctionnement de la photodiode indépendant de la polarisation du rayonnement lumineux incident est assuré par une structure périodique 220, présentant une périodicité selon deux dimensions, et avec les mêmes dimensions des plots considérés dans chacune de ces deux dimensions.

Le pas P de la structure périodique 220 est avantageusement supérieur au rapport $\dfrac{\lambda}{n_{eff}}$, et inférieur au

rapport $\dfrac{\lambda}{n_{ginf}}$ , avec :

- $\lambda$ la longueur d'onde que la photodiode est destinée à détecter,
- $n_{eff}$ l'indice effectif du guide d'onde formé dans la photodiode, égal en première approximation à l'indice de réfraction de la couche 210 en matériau semi-conducteur, et
- $n_{ginf}$, l'indice de réfraction de la première couche bas indice 230.

En d'autres termes, la photodiode étant destinée à détecter un rayonnement à une longueur d'onde dite d'intérêt, la structure périodique présente un pas P :

- supérieur au rapport de la longueur d'onde d'intérêt divisée par l'indice de réfraction de la couche en matériau semi-conducteur ; et
- inférieur au rapport de la longueur d'onde d'intérêt divisée par l'indice de réfraction de la première couche bas indice.

En pratique, le pas P est compris généralement entre 100 nm et 1000 nm, plus préférentiellement entre 200 nm et 700 nm. En prenant l'exemple d'une première couche bas indice en dioxyde de silicium (SiOz), et une couche en matériau semi-conducteur en silicium (Si), le pas P est compris entre 230 nm et 580 nm.

Une méthode pour déterminer des dimensions optimales de la photodiode selon l'invention peut consister à :

- fixer un pas P, dans les limites précisées ci-dessus ;
- fixer une hauteur $h_1$, dite profondeur du réseau ; puis
- ajuster la largeur $a$ des plots et l'épaisseur $h=h_1+h_2$ par optimisation d'une efficacité quantique calculée par simulation numérique.

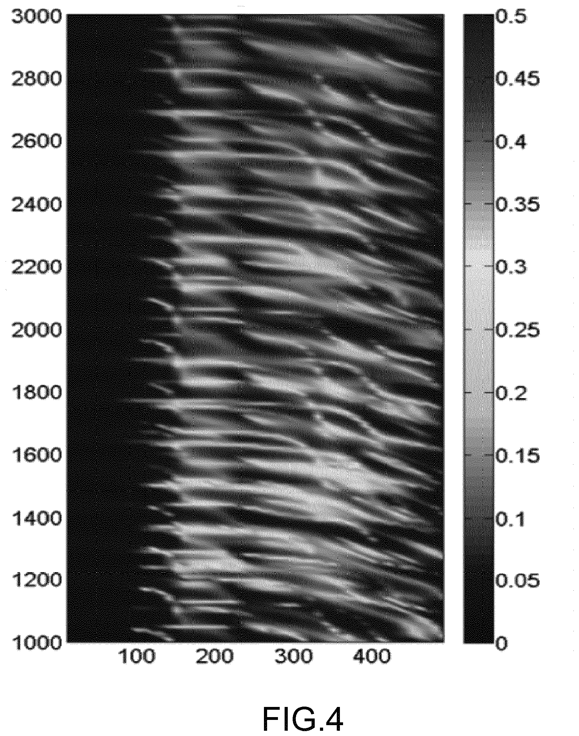

La figure 4 représente l'efficacité quantique à 850 nm dans une photodiode selon l'invention, en fonction de la largeur $a$ des plots (axe des abscisses) et de l'épaisseur $h=h_1+h_2$ de la structure périodique et de la couche en matériau semi-conducteur, toutes deux en silicium. On a fixé P=500 nm et $h_1$=300 nm.

On identifie ainsi des couples de largeur $a$ et d'épaisseur $h=h_1+h_2$, correspondant à de plus grandes efficacités quantiques. On choisit de préférence un couple, situé sur la figure 4, dans une large zone associée à de grandes efficacités quantiques. On bénéficie ainsi d'une bonne tolérance sur les dimensions de la photodiode. Ainsi, on choisit par exemple h=1550 nm et $a$=350 nm. h=1550 correspond à environ 5 à 10 fois la longueur d'onde dans le matériau de la couche en matériau semi-conducteur 110 :

$$\frac{1550\ nm}{7} \approx \frac{longueur\ d'onde\ dans\ le\ vide\ que\ la\ photodiode\ est\ adaptée\ à\ détecter : 850\ nm}{indice\ du\ silicium : 3,65}$$

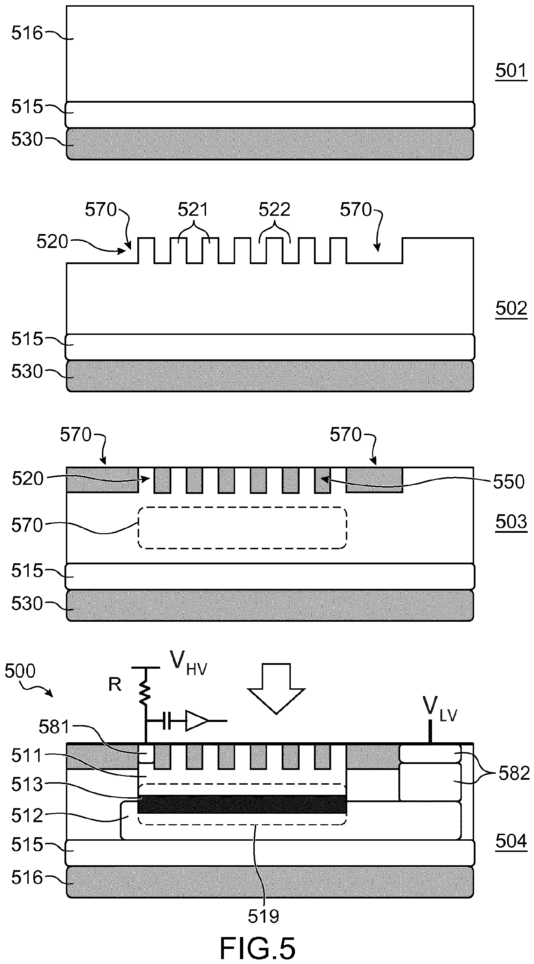

On décrit en référence à la figure 5, un procédé de réalisation d'un exemple d'une photodiode telle qu'illustrée schématiquement à la figure 2. De préférence, plusieurs photodiodes sont fabriquées simultanément selon ce procédé, formant ainsi une matrice de photodiodes selon l'invention.

On part d'un substrat dit silicium sur isolant (ou SOI, pour l'anglais « silicon on insulator »), formé par une fine couche de silicium sur une couche de dioxyde de silicium. Le dioxyde de silicium forme la première couche bas indice 530.

La fine couche de silicium peut être épaissie, puis dopée N ou P. On obtient la couche 515. Par exemple, la couche 515 est épaissie et présente par exemple un dopage du même type que le dopage d'une zone dopée qui la recouvre in fine dans la photodiode (ici un dopage P). En variante, la couche 515 reste fine et présente un dopage du type opposé au dopage d'une zone dopée qui la recouvre in fine dans la photodiode, afin d'éviter la remontée vers la surface de porteurs générés par les défauts de l'interface entre la première couche bas indice 530 et la couche de silicium 515.

Dans une première étape 501, on dépose par épitaxie sur la couche 515, une couche 516 de silicium faiblement dopé P. La couche 516 (et le cas échéant la couche 515) forme un bloc en matériau semi-conducteur.

A l'étape 502, on réalise, dans une même étape de gravure, la structure périodique 520 selon l'invention et des tranchées d'isolation 570. Les tranchées d'isolation présentent ainsi une profondeur égale à la hauteur pic-vallée des plots 521 de la structure périodique.

Les tranchées d'isolation 570 sont destinées à séparer des photodiodes voisines d'une même matrice de photodiodes, et sont nommées STI (pour l'anglais *« Shallow Trench Isolation »*).

La gravure de la structure périodique sépare, dans la couche en silicium 516, une structure périodique 520 selon l'invention et une couche qui formera la couche en matériau semi-conducteur selon l'invention, après définition des zones dopées.

L'étape de gravure de tranchées d'isolation est communément mise en oeuvre pour fabriquer une matrice de photodiodes selon l'invention, de sorte que la mise en oeuvre de l'invention oblige simplement à modifier un masque utilisé pour la gravure.

De préférence, les surfaces gravées sont passivées par une fine couche d'oxyde thermique.

A l'étape 503, les tranchées d'isolation 570 et les espaces 522 entre les plots 521 de la structure périodique 520 sont remplis par un oxyde déposé par plasma, par exemple du dioxyde de silicium. Cet oxyde forme le matériau bas indice selon l'invention, situé entre les plots de la structure périodique (deuxième couche bas indice 550).

La région de haute sensibilité 570, telle que décrite en référence à la figure 3, est entourée par des pointillés.

Dans une étape 504, on réalise une jonction PN sous la structure périodique 520, et dans la région de haute sensibilité 570.

Cette jonction PN est formée par implantation ionique, formant dans la couche 516 et sous la structure périodique, une zone dopée N, 511, et une zone dopée P, 512. En variante, la couche 515 est épaissie et fortement dopée P, et la couche 516 est dopée N, ce qui forme une jonction PN.

La zone dopée N et la zone dopée P sont séparées par la jonction PN, au niveau de laquelle se trouvera (après application d'une tension de polarisation adaptée) une zone d'avalanche 513.

La jonction PN est de préférence suffisamment éloignée de la structure périodique pour que la zone d'avalanche 513 n'empiète pas sur la structure périodique 520. Par exemple, la jonction PN est située à plus de 200 nm sous la structure périodique. Pour cela, la zone dopée N 511 est réalisée par implantation par exemple de phosphore entre 100 et 200 keV.

La structure périodique 520 peut rester non dopée. En variante, la structure périodique est dopée N, comme la zone dopée supérieure 511.

La zone dopée P, 512, est connectée à la surface de la photodiode par des régions fortement dopées P 582 formées par plusieurs implantations successives.

La zone dopée N, 511, est connectée à la surface de la photodiode par une unique région fortement dopée N 581, située dans un unique plot de la structure périodique. La région 581 est formée par implantation ionique à faible énergie, et se trouve de préférence au bord de la photodiode.

La zone dopée N, 511, est reliée à un potentiel $V_{HV}$, via la région 581 et un premier connecteur électrique (non représenté). La zone dopée P, 512, est reliée à un potentiel $V_{LV}$, via les régions 582 et un second connecteur électrique (non représenté). Le potentiel $V_{HV}$ est très supérieur au potentiel $V_{LV}$. Les potentiels électriques $V_{LV}$ et $V_{HV}$ définissent ensemble une tension de polarisation de la photodiode supérieure à sa tension de claquage, pour former une photodiode de type SPAD. En particulier la zone dopée P, 512, peut être reliée à la masse, et la zone dopée N, 511, peut être reliée à une source de tension par l'intermédiaire d'une résistance d'extinction R (communément nommée résistance de quench) servant à arrêter le phénomène d'avalanche (R=100 kΩ par exemple).

Le fait que la zone dopée N ne soit pas reliée au potentiel $V_{HV}$ par chacun des plots de la structure périodique participe également à arrêter le phénomène d'avalanche.

La mesure de la tension aux bornes de la photodiode 500 est réalisée par un montage amplificateur suiveur.

On peut réaliser une variante de la photodiode décrite ci-dessus, en inversant tous les dopages N et P.

On peut également former la première couche bas indice dans une couche de dioxyde de silicium plus épaisse que l'oxyde isolant d'un SOI standard.

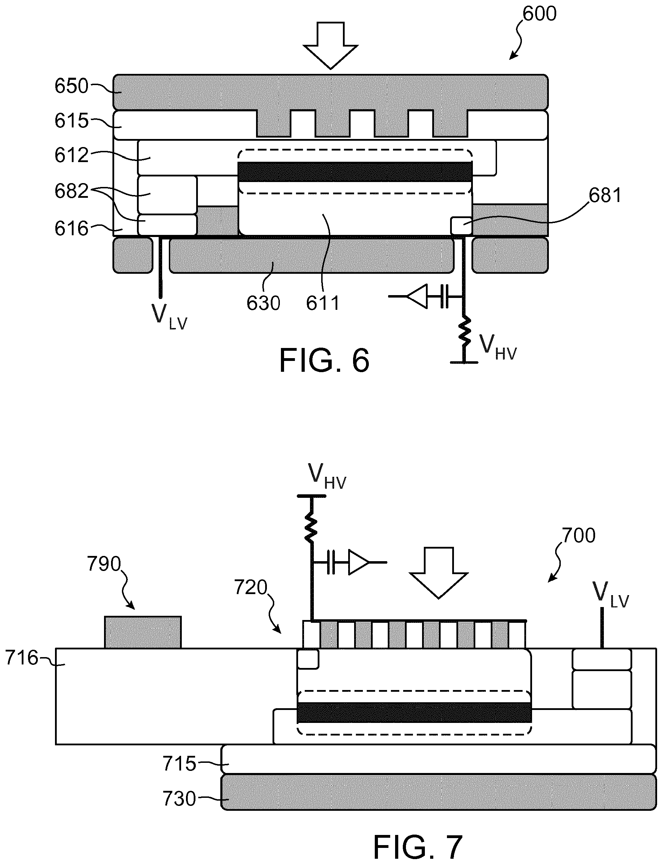

La figure 6 illustre un troisième mode de réalisation d'une photodiode 600 selon l'invention.

La photodiode illustrée en figure 6 ne diffère du mode de réalisation de la figure 5 qu'en ce qu'elle est adaptée à mesurer des photons arrivant sur la photodiode du côté du SOI initial, et non du côté opposé à celui-ci. On parle d'illumination BSI, pour l'anglais *« BackSide Illumination »*.

On part d'un SOI tel que décrit en référence à la figure 6. Dans ce mode de réalisation, les étapes technologiques sont faites sur la face avant d'un SOI, puis l'ensemble réalisé est retourné.

Le silicium du SOI est épaissi pour former une couche de silicium 615 dopée N. Une couche de silicium 616 est réalisée par épitaxie au-dessus de la couche 615. Des tranchées sont creusées entre les futures photodiodes, remplies ensuite par du dioxyde de silicium, ce dioxyde de silicium recouvrant entièrement la couche 615 et formant la première couche bas indice 630 selon l'invention.

On réalise dans la couche de silicium 616 une jonction PN entre une zone dopée N 611 et une zone dopée P 612, et des régions fortement dopées 681, 682 destinées à relier la zone dopée N 611 et la zone dopée P 612 au potentiel $V_{HV}$, respectivement $V_{LV}$. La première couche bas indice 630 peut être gravée localement pour laisser passer des connecteurs électriques.

Ensuite, on retourne l'empilement ainsi formé, et on grave sa surface supérieure pour retirer l'oxyde du SOI et graver la couche de silicium 615 afin d'y former la structure périodique 620. La structure périodique est ensuite recouverte d'une couche en dioxyde de silicium formant la deuxième couche bas indice 650.

Ici, les faces gravées de la structure périodique ne sont pas passivées par dépôt d'oxyde, et la couche en silicium 615 est dopée N (dopage du type opposé à celui de la zone dopée adjacente), afin d'éviter que des porteurs générés par les défauts d'interface de la structure périodique ne diffusent jusque dans la zone d'avalanche.

La figure 7 illustre un quatrième mode de réalisation d'une photodiode 700 selon l'invention.

La photodiode illustrée en figure 7 ne diffère du mode de réalisation de la figure 5 qu'en ce que la structure périodique 720 n'est pas formée dans le même bloc de silicium que la couche en matériau semi-conducteur, mais dans une couche d'un matériau différent.

Par exemple, après avoir réalisé par épitaxie la couche de silicium 716 sur un SOI, on recouvre l'ensemble par une couche de silicium poly-cristallin, dans laquelle sera gravée la structure périodique selon l'invention, et servant également de grille pour un transistor 790 voisin.

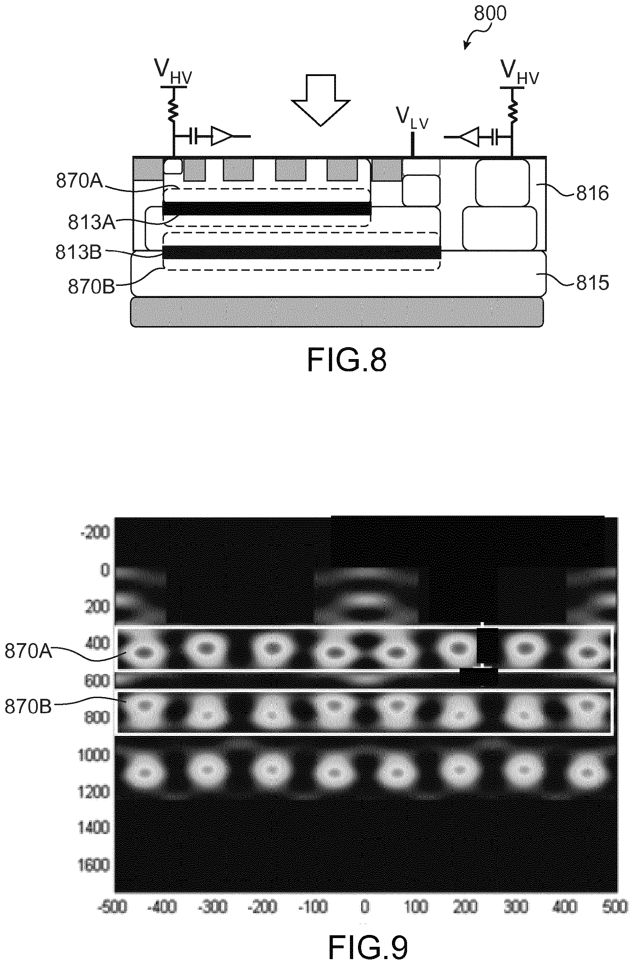

La figure 8 illustre un cinquième mode de réalisation d'une photodiode 800 selon l'invention.

La photodiode illustrée en figure 8 ne diffère du mode de réalisation de la figure 5 qu'en ce qu'elle présente deux jonctions PN superposées, associées chacune à une zone d'avalanche 813A, 813B, et partageant une même zone dopée intercalaire.

En particulier, une zone dopée P est située entre deux zones dopées N, formant une jonction PN de chaque côté.

Les deux jonctions PN sont situées chacune dans une région de haute sensibilité 870A, 870B telle que décrite en référence à la figure 3. Ces régions de haute sensibilité 870A, 870B sont illustrées à la figure 9, montrant la répartition de champ électromagnétique dans la photodiode. Les régions de haute sensibilité 870A, 870B sont superposées, et séparées par une sous-couche dans laquelle l'intensité du champ électromagnétique est très faible (intensité moyenne au moins 10 fois moindre que dans les régions 870A, 870B).

Une telle photodiode est obtenue à l'aide d'un procédé tel qu'illustré en figure 5, la couche en silicium 816 étant cette fois faiblement dopée P, sur une couche en silicium 815 dopée N et formant l'une parmi les deux zones dopées N.

La photodiode 800 forme ainsi un détecteur bi-spectral, chaque jonction PN étant dédiée à la détection d'une longueur d'onde différente.

L'invention n'est pas limitée aux exemples décrits ci-dessus, et de nombreuses variantes pourront être mises en oeuvre sans sortir du cadre de la présente invention.

Par exemple, la structure périodique pourra se présenter sous la forme d'une grille, forme complémentaire d'un maillage carré de plots cubiques.

L'invention est particulièrement avantageuse pour une couche en matériau semi-conducteur constituée de silicium, ce matériau présentant une faible absorption, en particulier dans le rouge et l'infrarouge. Cependant, l'invention n'est pas limitée à ce matériau semi-conducteur ni à ces longueurs d'onde.

## Revendications

1.  Photodiode (100 ; 200; 500; 600 ; 700 ; 800) de type SPAD, présentant une couche en matériau semi-conducteur (110 ; 210) comprenant une zone dopée N (111 ; 511 ; 611) et une zone dopée P (112 ; 512 ; 612), séparées par une jonction PN (114) avec une zone d'avalanche (113 ; 213 ; 513 ; 813A; 813B) qui s'étend dans et autour de la jonction PN, ladite photodiode comprenant en outre :

    - une première couche dite bas indice (130 ; 230 ; 530 ; 630 ; 730) ; et
    - une structure périodique (120 ; 220 ; 520 ; 620 ; 720), présentant une périodicité selon une ou deux dimensions associées chacune à un axe parallèle à une surface supérieure de la photodiode, et présentant une pluralité de motifs élémentaires répartis selon un pas, c'est-à-dire une pluralité de plots (121; 521) régulièrement espacés les uns des autres ;

    dans laquelle :

    - le pas P de la structure périodique (120 ; 220 ; 520 ; 620 ; 720) est supérieur au rapport $\frac{\lambda}{n_{eff}}$, et inférieur au rapport $\frac{\lambda}{n_{ginf}}$, avec $\lambda$ une longueur d'onde que la photodiode est destinée à détecter, $n_{eff}$ l'indice effectif d'un guide d'onde formé dans la photodiode égal en première approximation à l'indice de réfraction dans la couche en matériau semi-conducteur (110 ; 210), et $n_{ginf}$ l'indice de réfraction de la première couche bas indice (130 ; 230 ; 530 ; 630 ; 730) ;
- la première couche bas indice (130 ; 230 ; 530 ; 630; 730) présente un indice de réfraction inférieur à celui de la couche en matériau semi-conducteur et à celui de la structure périodique ; et
- la structure périodique (120 ; 220 ; 520 ; 620 ; 720) s'étend au-dessus de la jonction PN ;
- la couche en matériau semi-conducteur (110; 210) est intercalée entre la première couche bas indice et la structure périodique, avec la couche en matériau semi-conducteur (110; 210) qui s'étend directement sur la première couche bas indice (130; 230; 530; 630; 730), et avec la structure périodique (120 ; 220 ; 520 ; 620 ; 720) qui s'étend directement sur la couche en matériau semi-conducteur (110 ; 210),

- la structure périodique (120 ; 220 ; 520; 620) étant semiconductrice et formée dans un même bloc en matériau semi-conducteur que la couche en matériau semi-conducteur (110 ; 210) ou formée dans une couche en silicium poly-cristallin déposée sur la couche en matériau semi-conducteur.

2.  Photodiode (200; 500; 600; 700 ; 800) selon la revendication 1, **caractérisée en ce que** la structure périodique comprend une pluralité de plots (212 ; 521) régulièrement espacés, les espaces (122 ; 222 ; 522) entre les plots étant au moins partiellement remplis par un matériau dit matériau bas indice, présentant un indice de réfraction inférieur à celui de la couche en matériau semi-conducteur et à celui de la structure périodique.

3.  Photodiode (100 ; 200 ; 500 ; 700; 800) selon l'une des revendications 1 ou 2, **caractérisée en ce que** la structure périodique (520 ; 720) présente un dopage N ou P et **en ce qu'**un seul des motifs élémentaires est relié à un élément de contact électrique, pour polariser la photodiode.

4.  Photodiode (100 ; 200 ; 500 ; 600 ; 700 ; 800) selon l'une quelconque des revendications 1 à 3, **caractérisée en ce qu'**une différence entre l'indice de réfraction de la couche en matériau semi-conducteur (110; 210) et l'indice de réfraction de la première couche bas indice (130 ; 230 ; 530 ; 630 ; 730) est supérieure ou égale à 0,5.

5.  Photodiode (100 ; 200 ; 500 ; 600 ; 700 ; 800) selon l'une quelconque des revendications 1 à 4, **caractérisée en ce que** la structure périodique (120 ; 220 ; 520 ; 620 ; 720) présente un pas (P) compris entre 100 nm et 1000 nm.

6.  Photodiode (100 ; 200 ; 500 ; 600 ; 700 ; 800) selon l'une quelconque des revendications 1 à 5, **caractérisée en ce que** l'épaisseur ($h_2$) de la couche en matériau semi-conducteur (110 ; 210) est comprise entre 0,5 $\mu$m et 3 $\mu$m.

7.  Photodiode (100 ; 200 ; 500 ; 600 ; 700 ; 800) selon l'une quelconque des revendications 1 à 6, **caractérisée en ce que** la hauteur ($h_1$) des motifs élémentaires est inférieure à 1 $\mu$m.

8.  Photodiode (100 ; 200 ; 500 ; 600 ; 700 ; 800) selon l'une quelconque des revendications 1 à 7, **caractérisée en ce qu'**un rapport $\left(\frac{a}{P}\right)$ de la largeur (*a*) d'un plot, divisée par le pas (P) de la structure périodique (120 ; 220 ; 520 ; 620 ; 720) est compris entre 0,25 et 0,80.

9.  Photodiode (100 ; 200 ; 500 ; 600 ; 700 ; 800) selon l'une quelconque des revendications 1 à 8, **caractérisée en ce que** la structure périodique (120 ; 220 ; 520 ; 620 ; 720) forme un réseau en deux dimensions, le pas (P) de ce réseau étant identique dans chacune desdites deux dimensions.

10. Photodiode selon l'une quelconque des revendications 1 à 9, **caractérisée en ce que** la structure périodique a une forme de grille.

11. Matrice d'au moins deux photodiodes (200; 500; 800) selon l'une des revendications 1 à 10, **caractérisée en ce que** :

- la structure périodique comprend une pluralité de plots (212 ; 521) régulièrement espacés, les espaces (122 ; 222 ; 522) entre les plots étant au moins partiellement remplis par un matériau dit matériau bas indice, présentant un indice de réfraction inférieur à celui de la couche en matériau semi-conducteur et à celui de la structure périodique ; et
- les structures périodiques (220 ; 520) voisines sont séparées par des tranchées (570) remplies par ledit matériau bas indice.

**12.** Procédé de fabrication d'une matrice de photodiodes (200; 500; 800) selon la revendication 11, **caractérisé en ce qu'**il comprend les étapes suivantes :

- structuration d'une région supérieure d'un bloc (516) en matériau semi-conducteur, pour former un ensemble constitué par une pluralité de structures périodiques (520) montées sur une couche en matériau semi-conducteur ;
- gravure de tranchées (570) entre deux structures périodiques (520) voisines, les étapes de gravure de tranchées et de structuration étant réalisées par une unique étape de gravure (502) ; et
- dépôt (503) du matériau bas indice, remplissant les tranchées (570) et les espaces (522) entre des plots formant les structures périodiques, ledit matériau bas indice présentant un indice de réfraction inférieur à celui du bloc en matériau semi-conducteur.

**Patentansprüche**

**1.** Fotodiode (100; 200; 500; 600; 700; 800) vom Typ SPAD, die eine Schicht aus Halbleitermaterial (110; 210) aufweist, welche eine N-dotierte Zone (111; 511; 611) und eine P-dotierte Zone (112; 512; 612) umfasst, die durch einen PN-Übergang (114) mit einer Lawinenzone (113; 213; 513; 813A; 813B), welche sich in und um den PN-Übergang herum erstreckt, getrennt sind, wobei die Fotodiode weiter umfasst:

- eine erste sogenannte Niedrigindex-Schicht (130; 230; 530; 630; 730); und
- eine periodische Struktur (120; 220; 520; 620; 720), die eine Periodizität in einer oder zwei Dimensionen aufweist, welche jeweils mit einer zu einer oberen Fläche der Fotodiode parallelen Achse verknüpft sind, und eine Vielzahl von elementaren Mustern aufweist, die gemäß einer Teilung verteilt sind, das heißt eine Vielzahl von Stiften (121; 521), die regelmäßig voneinander beabstandet sind;

wobei:

- die Teilung P der periodischen Struktur (120; 220; 520; 620; 720) größer ist als das Verhältnis $\frac{\lambda}{n_{eff}}$ und kleiner als das Verhältnis $\frac{\lambda}{n_{ginf}}$, wobei a eine Wellenlänge ist, die die Fotodiode erkennen soll, $n_{eff}$ der effektive Index eines in der Fotodiode gebildeten Wellenleiters ist, der in erster Näherung gleich dem Brechungsindex in der Schicht aus Halbleitermaterial (110; 210) ist, und $n_{ginf}$ der Brechungsindex der ersten Niedrigindex-Schicht (130; 230; 530; 630; 730) ist;
- die erste Niedrigindex-Schicht (130; 230; 530; 630; 730) einen kleineren Brechungsindex als den der Schicht aus Halbleitermaterial und den der periodischen Struktur aufweist; und
- die periodische Struktur (120; 220; 520; 620; 720) sich über dem PN-Übergang erstreckt;
- die Schicht aus Halbleitermaterial (110; 210) zwischen der ersten Niedrigindex-Schicht und der periodischen Struktur eingefügt ist, wobei die Schicht aus Halbleitermaterial (110; 210) sich direkt auf der ersten Niedrigindex-Schicht (130; 230; 530; 630; 730) erstreckt, und wobei die periodische Struktur (120; 220; 520; 620; 720) sich direkt auf der Schicht aus Halbleitermaterial (110; 210) erstreckt,
- wobei die periodische Struktur (120; 220; 520; 620) halbleitend und in demselben Block aus Halbleitermaterial gebildet ist wie die Schicht aus Halbleitermaterial (110; 210), oder in einer Schicht aus polykristallinem Silicium gebildet ist, welche auf der Schicht aus Halbleitermaterial abgeschieden ist.

**2.** Fotodiode (200; 500; 600; 700; 800) nach Anspruch 1, **dadurch gekennzeichnet, dass** die periodische Struktur eine Vielzahl von regelmäßig beabstandeten Stiften (212; 521) umfasst, wobei die Abstände (122; 222; 522) zwischen den Stiften mindestens teilweise mit einem als Niedrigindex-Material bezeichneten Material gefüllt sind, welches einen kleineren Brechungsindex als den der Schicht aus Halbleitermaterial und den der periodischen Struktur aufweist.

**3.** Fotodiode (100; 200; 500; 700; 800) nach einem der Ansprüche 1 oder 2, **dadurch gekennzeichnet, dass** die periodische Struktur (520; 720) eine N- oder P-Dotierung aufweist, und dadurch, dass ein einziges der elementaren Muster mit einem elektrischen Kontaktelement verbunden ist, um die Photodiode zu polarisieren.

**4.** Fotodiode (100; 200; 500; 600; 700; 800) nach einem der Ansprüche 1 bis 3, **dadurch gekennzeichnet, dass** eine Differenz zwischen dem Brechungsindex der Schicht aus Halbleitermaterial (110; 210) und dem Brechungsindex der ersten Niedrigindex-Schicht (130; 230; 530; 630; 730) größer oder gleich 0,5 ist.

5.  Fotodiode (100; 200; 500; 600; 700; 800) nach einem der Ansprüche 1 bis 4, **dadurch gekennzeichnet, dass** die periodische Struktur (120; 220; 520; 620; 720) eine Teilung (P) im Bereich zwischen 100 nm und 1000 nm aufweist.

6.  Fotodiode (100; 200; 500; 600; 700; 800) nach einem der Ansprüche 1 bis 5, **dadurch gekennzeichnet, dass** die Dicke ($h_2$) der Schicht aus Halbleitermaterial (110; 210) im Bereich zwischen 0,5 $\mu$m und 3 $\mu$m liegt.

7.  Fotodiode (100; 200; 500; 600; 700; 800) nach einem der Ansprüche 1 bis 6, **dadurch gekennzeichnet, dass** die Höhe ($h_1$) der elementaren Muster kleiner als 1 $\mu$m ist.

8.  Fotodiode (100; 200; 500; 600; 700; 800) nach einem der Ansprüche 1 bis 7, **dadurch gekennzeichnet, dass** ein Verhältnis $\frac{a}{P}$) der Breite (*a*) eines Stiftes, geteilt durch die Teilung (P) der periodischen Struktur (120; 220; 520; 620; 720), im Bereich zwischen 0,25 und 0,80 liegt.

9.  Fotodiode (100; 200; 500; 600; 700; 800) nach einem der Ansprüche 1 bis 8, **dadurch gekennzeichnet, dass** die periodische Struktur (120; 220; 520; 620; 720) ein zweidimensionales Netz bildet, wobei die Teilung (P) dieses Netzes in jeder der zwei Dimensionen identisch ist.

10. Fotodiode nach einem der Ansprüche 1 bis 9, **dadurch gekennzeichnet, dass** die periodische Struktur eine Gitterform aufweist.

11. Matrix aus mindestens zwei Photodioden (200; 500; 800) nach einem der Ansprüche 1 bis 10, **dadurch gekennzeichnet, dass**:

    - die periodische Struktur eine Vielzahl von regelmäßig beabstandeten Stiften (212; 521) umfasst, wobei die Abstände (122; 222; 522) zwischen den Stiften mindestens teilweise mit einem als Niedrigindex-Material bezeichneten Material gefüllt sind, das einen kleineren Brechungsindex als den der Schicht aus Halbleitermaterial und den der periodischen Struktur aufweist; und
    - die aneinandergrenzenden periodischen Strukturen (220; 520) durch Gräben (570) getrennt sind, welche mit dem Niedrigindex-Material gefüllt sind.

12. Verfahren zur Herstellung einer Matrix aus Fotodioden (200; 500; 800) nach Anspruch 11, **dadurch gekennzeichnet, dass** es die folgenden Schritte umfasst:

    - Strukturieren einer oberen Region eines Blocks (516) aus Halbleitermaterial, um eine Anordnung zu bilden, die aus einer Vielzahl von auf einer Schicht aus Halbleitermaterial angebrachten periodischen Strukturen (520) besteht;
    - Ätzen von Gräben (570) zwischen zwei aneinandergrenzenden periodischen Strukturen (520), wobei die Schritte des Ätzens von Gräben und des Strukturierens mit einem einzigen Ätzschritt (502) ausgeführt werden; und
    - Abscheiden (503) des Niedrigindex-Materials, wobei die Gräben (570) und die Abstände (520) zwischen Stiften, welche die periodischen Strukturen bilden, gefüllt werden, wobei das Niedrigindex-Material einen kleineren Brechungsindex als den des Blocks aus Halbleitermaterial aufweist.

**Claims**

1.  Photodiode (100; 200; 500; 600; 700; 800) of SPAD type, having a layer made of semiconductor material (110; 210) including an N doped zone (111; 511 ; 611) and a P doped zone (112; 512; 612), separated by PN junction (114) with an avalanche zone (113 ; 213; 513; 813A; 813B) extending in and around the PN junction, said photodiode further comprising

    - a first so-called low index layer (130; 230; 530; 630; 730); and
    - a periodic structure (120 ; 220 ; 520 ; 620 ; 720) having a plurality of elementary patterns, that is to say a plurality of pads (121; 521) regularly spaced apart from each other and arranged according a pitch ;

wherein:

the pitch P of the periodic structure (120; 220; 520; 620; 720) is greater than the ratio $\frac{\lambda}{n_{eff}}$, and less than the ratio $\frac{\lambda}{n_{ginf}}$, with:

- $\lambda$ the wavelength that the photodiode is intended to detect,
- $n_{eff}$ the actual index of the waveguide formed in the photodiode, equal as a first approximation to the refractive index of the layer (110; 210) made of semiconductor material, and
- $n_{ginf}$, the refractive index of the first low index layer (130; 230; 530; 630; 730)

the first low index layer (130; 230; 530; 630; 730) having a refractive index less than that of the semiconductor material layer and than that of the periodic structure, and the semiconductor material layer (110; 210) being intercalated between the first low index layer and the periodic structure,

- the periodic structure (120; 220; 520; 620; 720) being arranged on the PN junction
- the semiconductor material layer (110 ; 210) being intercalated between the first low index layer (130; 230; 530; 630; 730) and the periodic structure (120; 220; 520 ; 620; 720) that is directly lying on the the semiconductor material layer (110 ; 210),
- the periodic structure (120; 220; 520; 620; 720) being made of semiconductor and in a same semi-conductor bloc that the semiconductor material layer (110 ; 210) or being formed in a polycrystalline layer formed on the semiconductor material layer.

2. Photodiode (200 ; 500 ; 600 ; 700 ; 800) according to claim 1, **characterised in that** the periodic structure includes a plurality of pads (212; 521) regularly spaced apart, the spaces (122 ; 222 ; 522) between the pads being at least partially filled with a so-called low index material, having a refractive index less than that of the semiconductor material layer and than that of the periodic structure.

3. Photodiode (100 ; 200 ; 500 ; 700; 800) according to any of the claims 1 or 2, **characterised in that** the periodic structure (520; 720) has an N or P doping and **in that** only one of the elementary patterns is connected to an electrical contact element, for biasing the photodiode.

4. Photodiode (100 ; 200 ; 500 ; 600 ; 700; 800) according to any of the claims 1 to 3, **characterised in that** a difference between the refractive index of the semiconductor material layer (110; 210) and the refractive index of the first low index layer (130 ; 230 ; 530 ; 630 ; 730) is greater than or equal to 0.5.

5. Photodiode (100 ; 200; 500 ; 600 ; 700 ; 800) according to any of the claims 1 to 4, **characterised in that** the periodic structure (120 ; 220 ; 520 ; 620 ; 720) has a pitch (P) comprised between 100 nm and 1000 nm.

6. Photodiode (100 ; 200 ; 500 ; 600 ; 700 ; 800) according to any of the claims 1 to 5, **characterised in that** the thickness ($h_2$) of the semiconductor material layer (110; 210) is comprised between 0.5 $\mu$m and 3 $\mu$m.

7. Photodiode (100 ; 200 ; 500 ; 600 ; 700; 800) according to any of the claims 1 to 6, **characterised in that** the height ($h_1$) of the elementary patterns is less than 1 $\mu$m.

8. Photodiode (100 ; 200 ; 500 ; 600 ; 700 ; 800) according to any of the claims 1 to 7, **characterised in that** a ratio $\left(\frac{a}{P}\right)$ of the width ($a$) of a pad, divided by the pitch (P) of the periodic structure (120; 220; 520; 620; 720) is comprised between 0.25 and 0.80.

9. Photodiode (100 ; 200 ; 500 ; 600 ; 700 ; 800) according to any of the claims 1 to 8, **characterised in that** the periodic structure (120; 220; 520; 620; 720) forms a two-dimensional network, the pitch (P) of this network being identical in each of said two dimensions.

10. Photodiode (100; 200; 500; 600; 800) according to any of the claims 1 to 9, **characterised in that** the periodic structure (120; 220; 520; 620) has a grid shape.

**11.** Array of at least two photodiodes (200; 500; 800) according to any of the claims 1 to 10 **characterised in that**:

- the periodic structure includes a plurality of pads (212; 521) regularly spaced apart, the spaces (122; 222; 522) between the pads being at least partially filled with a material known as low index material, having a refractive index less than that of the semiconductor material layer and than that of the periodic structure; and
- the neighbouring periodic structures (220; 520) are separated by trenches (570) filled with said low index material.

**12.** Method of manufacturing a photodiode (100; 200; 500; 600; 800) according to claim 11, **characterised in that** it includes the following steps:

- structuring an upper region of a semiconductor material block (516), to form an assembly constituted of a plurality of periodic structures (520) mounted on a semiconductor material layer;
- etching of trenches (570) between two neighbouring periodic structures (520), the steps of etching of trenches and structuring being carried out by a single etching step (502); and
- deposition (503) of the low index material, filling the trenches (570) and the spaces (522) between the pads forming the periodic structures, said low index material having a refractive index less than that of the semiconductor material block.

FIG.1

FIG.2

FIG.3

FIG.4

516

515

530

501

570 521 522 570

520

515

530

502

570 570

520 550

570

503

515

530

500 $V_{HV}$

R

$V_{LV}$

581

511

513 582

512

519

504

515

516

FIG.5

**FIG. 6**

**FIG. 7**

FIG.8

FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011018086 A1

- JP H03152978 A

**Littérature non-brevet citée dans la description**

- Photonic technology in quantum information challenges quantum limitation. *Proc. of SPIE,* 2007, vol. 6827, 68270F
- 0 Gbps silicon waveguide-integrated infrared avalanche photodiode. *OPTICS EXPRESS,* 12 Août 2013, vol. 21 (17), 19530-19537

- **JIAN MA.** High-efficiency and low-jitter Silicon single-photon avalanche diodes based on nanophotonic absorption enhancement. *arXiv.org,* 06 Mai 2015, 1-7